(19) **Europäisches Patentamt**

**European Patent Office**

**Office européen des brevets**

(11) Numéro de publication : **0 544 550 A1**

(12) # DEMANDE DE BREVET EUROPEEN

(21) Numéro de dépôt : **92402917.6**

(22) Date de dépôt : **26.10.92**

(51) Int. Cl.⁵ : **H03L 7/23,** H03L 7/099

(30) Priorité : **29.10.91 FR 9113386**

(43) Date de publication de la demande :
**02.06.93 Bulletin 93/22**

(84) Etats contractants désignés :
**AT DE GB IT**

(71) Demandeur : **ERFATEC**
**1, Centre Administratif des 7 Mares**
**F-78990 Elancourt (FR)**

(72) Inventeur : **Remy, Joel**
**68, Rue de Port Royal**
**F-78470 Saint Remy Les Chevreuse (FR)**

(74) Mandataire : **de Saint-Palais, Arnaud Marie et**
**al**
**CABINET MOUTARD 35, Avenue Victor Hugo**
**F-78960 Voisins le Bretonneux (FR)**

(54) **Synthétiseur à boucle auxiliaire de référence spectrale.**

(57)    Le synthétiseur selon l'invention comporte un générateur de fréquence des petits pas (21) engendrant une première fréquence (Fe) qui est appliquée à un diviseur (22) à taux variable (N) dont la fréquence de sortie est comparée à un comparateur de phase (25), à un battement soustractif issu d'un mélangeur (24) qui reçoit une deuxième fréquence (Fq) en provenance d'un oscillateur (23) à résonateur piézoélectrique et une fréquence de référence (Fp), la fréquence de sortie (Fs) étant obtenue à partir de la fréquence de l'oscillateur (23) divisée dans un diviseur à taux fixe (R) et multipliée par des moyens de multiplication de fréquence (27), par le même taux variable (N).
    L'invention permet d'obtenir des signaux de sortie présentant un bonne pureté spectrale.

FIG.3

EP 0 544 550 A1

La présente invention concerne un synthétiseur comportant un générateur de fréquence des petits pas agissant à travers une boucle d'asservissement de phase sur un oscillateur dont la fréquence constitue la référence de la boucle de génération des grands pas.

D'une manière générale, on sait qu'un synthétiseur à simple boucle d'asservissement de phase comprend un oscillateur commandé par une tension, un diviseur logique à taux variable et un comparateur de phase qui reçoit une fréquence de référence égale aux pas.

Cette boucle simple présente un certain nombre de limitations et permet difficilement d'accroître le nombre de pas sans compromettre gravement la qualité du signal engendré.

En effet, les meilleures technologies utilisées pour la réalisation d'un comparateur phase-fréquence conduisent à des niveaux de bruit de l'ordre de - 150 dB/Hz pour une fréquence d'asservissement F de 1 MHz, cette valeur F diminuant selon une loi logarithmique du type 10 log F lorsque s'accroît la fréquence de référence qui constitue le pas.

Il est donc aisé de comprendre que lorsque, pour une fréquence de sortie donnée, la fréquence de référence Fp diminue tandis que le taux de division N du diviseur augmente, le gain sur le bruit au niveau du comparateur est sensiblement proportionnel à 10 log F et que la perte due au taux de multiplication est en 20 log N. Le résultat sur la sortie est donc une perte de qualité selon une loi en dix fois le logarithme de la fréquence du pas Fp.

La solution généralement utilisée pour obtenir un pas de résolution très fin, est de faire appel à une architecture de synthétiseur multiboucle beaucoup plus complexe et dans laquelle la présence de plusieurs fréquences variables non harmoniques entre elles risque de faire apparaître des raies spectrales parasites difficiles à éliminer.

Une approche intéressante de synthétiseur multiboucle est décrite dans le brevet britannique publié sous le No 1 303 631 et déposé le 1er mars 1969.

Toutefois, comme cela est exposé dans la suite, cette solution qui exige l'usage de circuits performants et complexes pour la génération des petits pas, ne permet pas d'obtenir des signaux de sortie présentant une bonne pureté spectrale.

L'invention a donc plus particulièrement pour but de supprimer cet inconvénient.

A cet effet, elle propose d'exploiter, de façon paradoxale, les propriétés de pureté spectrale des oscillateurs de type à résonateur piézoélectrique tels que les oscillateurs à quartz.

On sait que les oscillateurs de ce type, bien connus pour leur stabilité en fréquence, n'autorisent que de faibles excursions de fréquence et sont donc, a priori, inappropriés à la génération de fréquences multiples dans un synthétiseur de fréquence.

Contrairement à ce préjugé, l'invention prévoit :
- d'associer au générateur de petits pas, une boucle de verrouillage de phase utilisant un oscillateur du type à résonateur piézoélectrique, de manière à obtenir à la sortie de cette boucle, un signal présentant une haute pureté spectrale, et
- de programmer la fréquence des petits pas et le taux de division par N de manière à les rendre compatibles avec la faible excursion de fréquence de l'oscillateur à résonateur piézoélectrique.

D'une façon plus précise, le synthétiseur de fréquence selon l'invention comporte un générateur de fréquence des petits pas engendrant une première fréquence Fe qui est appliquée à un diviseur à taux variable N dont la fréquence de sortie est comparée, dans un comparateur de phase, à un battement soustractif issu d'un mélangeur suivi d'un filtre, ce mélangeur recevant, d'une part, une deuxième fréquence Fq en provenance d'un oscillateur et, d'autre part, une fréquence de référence Fp, ledit oscillateur étant commandé par ledit comparateur pour constituer une boucle d'asservissement de phase stable, la fréquence de sortie Fs du synthétiseur étant obtenue à partir de la fréquence de l'oscillateur divisée dans un diviseur à taux fixe R et multipliée par des moyens de multiplication de fréquence par le même taux variable N.

Selon l'invention, ce synthétiseur est plus particulièrement caractérisé en ce que le susdit oscillateur est du type à résonateur piézoélectrique, en ce que, en conséquence, le susdit taux N est déterminé en prenant la partie entière du quotient de R fois la fréquence de sortie Fs par une fréquence caractéristique de l'oscillateur, et en ce que la fréquence des petits pas Fe est égale à R fois la différence entre la fréquence Fs et le produit de la fréquence de référence Fp par N.

Avantageusement, la fréquence caractéristique de l'oscillateur pourra consister en sa fréquence minimum.

Toutefois, cette fréquence pourrait tout aussi bien consister en la fréquence maximum ou même en une fréquence intermédiaire telle que, par exemple, la fréquence moyenne.

Les particularités de l'invention apparaîtront mieux à la lecture de la description ci-après, se rapportant à l'art antérieur et à des modes d'exécution donnés à titre d'exemples non limitatifs, avec référence aux dessins annexés dans lesquels :

La figure 1 est un schéma synoptique illustrant le principe de fonctionnement d'un synthétiseur à simple boucle d'asservissement, de type connu intégrable dans un seul circuit monolithique ;

La figure 2 est un schéma synoptique d'un synthétiseur multiboucle de type connu ;

Les figures 3 et 4 représentent les schémas synoptiques de deux variantes d'exécution d'un synthétiseur de fréquence selon l'invention ;

La figure 5 est un schéma synoptique d'un synthétiseur du type de celui représenté sur la figure 3, mais utilisant un multiplicateur à taux variable N, spécialement conçu pour abaisser le niveau de bruit.

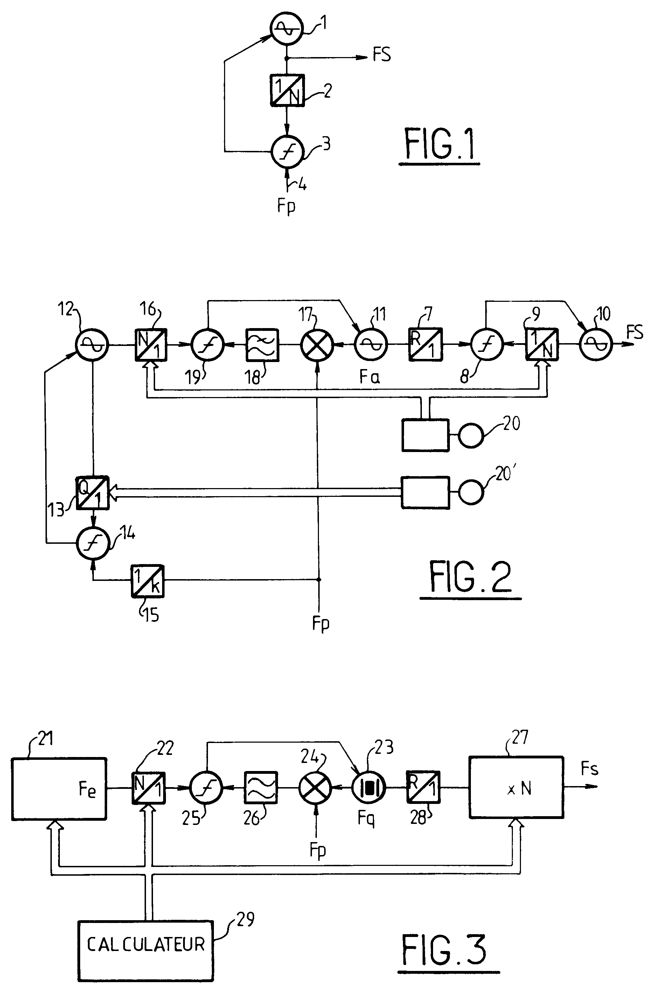

Tel que représenté sur la figure 1, le synthétiseur à simple boucle d'asservissement de phase comprend un oscillateur 1 commandé par une tension, un diviseur logique à taux variable 2 et un comparateur de phase 3 qui reçoit une fréquence de référence Fp égale au pas.

L'oscillateur 1 attaque le diviseur à taux variable 2 dont le taux de division par un entier N est programmable et dont la sortie est comparée à la fréquence de référence 4 de valeur Fp dans le comparateur phase-fréquence 3.

La fréquence de référence 4 peut provenir d'une horloge à quartz ou tout autre dispositif de stabilité suffisante.

Le comparateur 3 agit à travers le filtre de boucle sur la fréquence de l'oscillateur, le tout constituant un circuit bouclé, qui, une fois stabilisé, satisfait à l'équation :

$$Fs = N \times Fp$$

où

Fs est la fréquence de l'oscillateur 1,

Fp est la fréquence de référence qui constituera le pas.

Cette boucle simple présente les limitations précédemment évoquées.

Le synthétiseur multiboucle représenté figure 2, reprend les éléments du synthétiseur monoboucle, à savoir l'oscillateur de sortie 10, le diviseur à taux variable 9 et le comparateur 8. Toutefois, dans ce cas, le comparateur 8 reçoit comme référence le signal délivré par un oscillateur auxiliaire 11 délivrant une fréquence Fa.

Cet oscillateur 11 permet d'introduire entre les pas Fp, des pas plus fins au moyen d'une variation de fréquence permettant une interpolation entre les valeurs successives de N.

Un générateur de petits pas comprenant une boucle de phase similaire à celle de la figure 1 (qui comporte un oscillateur 12, un diviseur à taux variable Q (13) et un comparateur de phase 14 qui reçoit une fréquence Fp/k provenant d'un diviseur à taux variable 15), fournit une fréquence variable Fe ayant une expression de la forme $Fe = Fo + \delta$ dans laquelle Fo représente une partie fixe et $\delta$, la partie variable (en fait, la somme des petits pas de valeur Fp/k).

Cette fréquence Fe est divisée dans un diviseur 16 par le même taux N que celui du diviseur 9 et la fréquence obtenue sert de référence au comparateur 8.

La fréquence de l'oscillateur 11 est mélangée grâce à un mélangeur 17 à la fréquence Fp égale au grand pas et le battement soustractif filtré par un filtre passe-bas 18 attaque l'autre entrée d'un comparateur de phase 19 dont la sortie commande et asservit ce même oscillateur 11.

La fréquence Fa de l'oscillateur 11 est donc :

$$Fa = \frac{Fo + \delta + F_p}{N}$$

Ce qui donne après multiplication par N/R par la boucle de sortie, une fréquence de sortie Fs :

$$Fs = \frac{Fo + \delta + NF_p}{R}$$

La programmation de la fréquence est très simplement réalisée en programmant indépendamment les grands pas sur N et les petits pas sur Q au moyen des organes de commande 20 et 20' qui peuvent être de simples commutateurs.

La pureté spectrale du signal de sortie dépend essentiellement de celle de l'oscillateur 11 et du bruit introduit par la boucle de multiplication par N avec l'oscillateur 10, le diviseur 9 et le comparateur 8.

Pour conserver une bonne pureté spectrale avec ce dispositif, il est nécessaire de limiter la valeur de N afin de ne pas tomber dans le problème présenté dans le cas du synthétiseur monoboucle où le bruit du comparateur 19 devient la principale limitation, mais si N reste petit, l'oscillateur 11 doit couvrir une plage de fréquence importante pour interpoler entre les pas P, et il devient difficile d'obtenir la pureté spectrale requise au niveau de cet oscillateur.

De plus, la contribution du générateur des petits pas est importante et ces circuits doivent être performants et complexes.

Comme précédemment mentionné. l'objet de la présente invention est précisément de faire évoluer la structure connue pour repousser les limites qu'elle impose à la pureté spectrale du signal de sortie.

L'une des caractéristiques de l'invention réside dans l'utilisation d'un mode de programmation de la fréquence des petits pas et de la valeur N permettant de réduire l'excursion de fréquence de l'oscillateur 11 de manière à pouvoir utiliser pour cet oscillateur un résonateur piézoélectrique, par exemple à quartz.

La qualité d'un oscillateur à quartz est alors telle qu'il devient possible de réduire fortement sa bande d'asservissement en éliminant du même coup l'influence de la pureté spectrale des petits pas sur celle du signal de sortie.

L'invention, dans sa forme la plus générale, est représentée figure 3 et comporte des moyens de génération des plus petits pas 21, fournissant une fréquence Fe, un diviseur 22 par N et un oscillateur 23 à haute pureté spectrale mais corrélativement à très faible couverture de fréquence et dans le mode de réalisation préféré à résonateur à quartz.

La boucle d'asservissement comprend ici :

- un mélangeur 24 qui effectue le mélange de la fréquence de référence Fp avec la fréquence Fq de l'oscillateur 23, et

- un comparateur de phase qui reçoit la fréquence Fe/N fournie par le diviseur 22 ainsi que la fréquence de battement (filtrée par un filtre soustractif 26) émanant du mélangeur 24, ce comparateur de phase asservissant l'oscillateur 23.

La fréquence Fq fournie par l'oscillateur 23 est transmise à des moyens de multiplication 27 de fréquence par N, par l'intermédiaire d'un diviseur fixe 28 par un nombre R. Ces moyens de multiplication 27 délivrent le signal de sortie Fs.

La réduction et l'optimisation de la plage de fréquence couverte par l'oscillateur 23 est obtenue par le truchement d'un organe de calcul 29 qui prend en compte la fréquence de sortie désirée, le taux de division R du diviseur 28, la valeur de la référence Fp et, point capital, la fréquence minimum Fqmin de l'oscillateur 23.

Les deux relations appliquées sont :

$$(a) \qquad N = \frac{ENT\,[\,R.\,Fs\,]}{Fqmin}$$

$$(b) \qquad Fe = R\,[\,Fs - N.Fp\,]$$

L'application de la première relation (a) permet de déterminer la valeur de N qui correspond à la fréquence de l'oscillateur à quartz 23 la plus proche du minimum, qui, lorsque le résonateur est bien calé, correspond à la meilleure pureté spectrale qui se détériore avec le désaccord.

L'application de la deuxième relation (b) permet de déterminer la fréquence du générateur des petits pas 21 qui doit dans ce système se plier aux impératifs de pureté spectrale dictés par la technologie de l'oscillateur à quartz 23 dans le mode de réalisation préféré.

Il faut noter que l'excursion de fréquence de l'oscillateur à quartz 23 dépend de la valeur minimum de N suivant la relation :

$$Fqmax = Fqmin\,[\,1\,+\,1/Nmin\,]$$

La programmation des différents taux de division est réalisée par des moyens informatiques (organe de calcul 29) qui effectuent les calculs explicités plus haut et dont la réalisation ne présente aucune difficulté à l'homme de l'art.

La qualité de l'oscillateur à quartz 23 permet (en prenant une bande d'asservissement faible pour cet oscillateur 23) de filtrer le bruit introduit par la génération des petits pas et donc d'en simplifier la réalisation.

Le gain de performances en bruit de phase au niveau de l'oscillateur 23 est tel que la limitation se situe maintenant dans le bruit de comparaison et qu'une diminution de sa contribution permettrait de tirer tout le bénéfice du système.

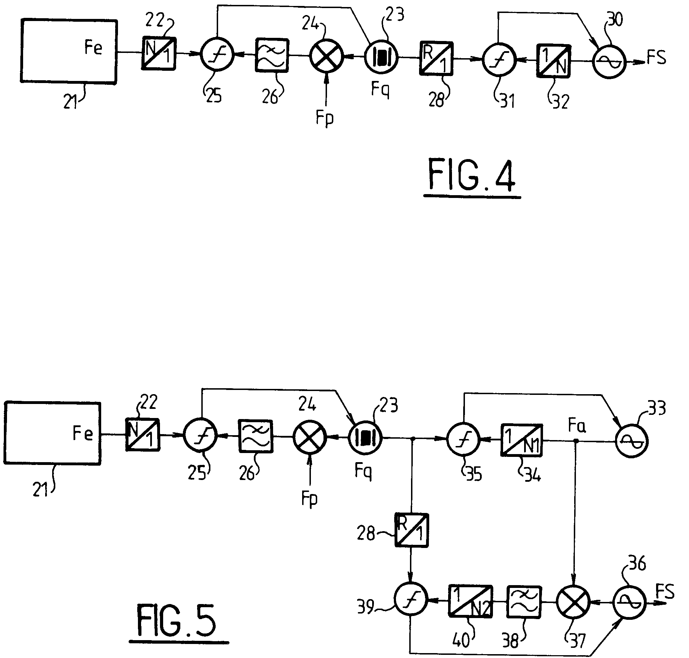

Les moyens de multiplication 27 peuvent comprendre, comme représenté sur la figure 4, une boucle faisant intervenir un oscillateur 30, un comparateur de phase 31 et un diviseur par N, 32, ces éléments étant agencés d'une façon similaire à ceux de la boucle 8, 9, 10 décrite en regard de la figure 2.

Toutefois, l'invention propose, dans le but de tirer un meilleur parti de la pureté spectrale obtenue par les moyens précédemment décrits, un multiplicateur à taux variable N à plus faible bruit.

Le principe de base de ce multiplicateur consiste en une décomposition de la boucle de multiplication comportant des éléments 30, 31 et 32 de la figure 4, en deux boucles distinctes dont l'une part directement de la fréquence Fq et permet, avec un facteur de multiplication peu élevé, d'approcher de la fréquence désirée, tandis qu'une seconde boucle partant de Fq/R permet d'ajouter le complément nécessaire avec également un facteur faible.

La figure 5 montre un synthétiseur complet conforme à cette variante de l'invention et dont les éléments de 21 à 28 sont identiques à ceux de la figure 4.

La première boucle de multiplication effectuant des pas de Fq met en oeuvre un oscillateur à fréquence variable 33, un diviseur à taux variable par N1, 34 et un comparateur de phase 35 qui reçoit en référence la fréquence Fq émanant de l'oscillateur 23 et asservit l'oscillateur 33 à une fréquence Fa.

La deuxième boucle comporte un oscillateur de sortie 36 dont la fréquence est mélangée dans un mélangeur 37 avec la fréquence Fa, ce mélangeur produisant un battement soustractif filtré par un filtre 38 et divisé par un nombre N2, au moyen d'un deuxième diviseur à taux variable 39.

Un comparateur de phase 39 connecté à la sortie des diviseurs 28 et 40 assure l'asservissement de l'oscillateur de sortie 36 (avec pour référence Fq/R).

Le rapport de multiplication équivalent N a pour valeur :

$$N = RN1 \pm N2$$

Le signe + ou - dépend du choix de N1 qui place l'oscillateur 34 en dessous ou au-dessus de l'oscillateur de sortie 36.

Diverses variantes de ce système peuvent être envisagées sans sortir du cadre de la présente invention, notamment la génération des petits pas peut faire appel à une ou plusieurs boucles, à une synthèse numérique à accumulateur de phase, etc...

De même, la multiplication par N peut être faite au moyen de multiplicateurs en boucle ouverte ou avec des boucles sans diviseurs programmable mais avec système d'approche analogique ou numérique.

Enfin, la structure du multiplicateur perfectionné de la figure 5 peut être modifiée par l'introduction d'un diviseur fixe entre Fq et le comparateur 35 ou, le principe peut être étendu en utilisant plus de deux boucles avec sommation algébrique des fréquences pour diminuer le bruit apporté par la multiplication.

## Revendications

1. Synthétiseur de fréquence à boucle auxiliaire de référence spectrale, comportant un générateur de fréquence des petits pas (21) engendrant une première fréquence (Fe) qui est appliquée à un diviseur (22) à taux variable (N) dont la fréquence de sortie est comparée dans un comparateur de phase (25), à un battement soustractif issu d'un mélangeur (24) suivi d'un filtre (26), ce mélangeur (24) recevant, d'une part, une deuxième fréquence (Fq) en provenance d'un oscillateur (23) et, d'autre part, une fréquence de référence (Fp), ledit oscillateur (23) étant commandé par ledit comparateur (25) pour constituer une boucle d'asservissement de phase stable, la fréquence de sortie (Fs) du synthétiseur étant obtenue à partir de la fréquence de l'oscillateur (23) divisée dans un diviseur (28) à taux fixe (R) et multipliée par des moyens de multiplication de fréquence (27) par le même taux variable (N),
caractérisé en ce que le susdit oscillateur (23) est du type à résonateur piézoélectrique, en ce que, en conséquence, le susdit taux (N) est déterminé en prenant la partie entière du quotient de (R) fois la fréquence de sortie (Fs) par une fréquence caractéristique de l'oscillateur (23), et en ce que la fréquence des petits pas (Fe) est égale à (R) fois la différence entre la fréquence (Fs) et le produit de la fréquence de référence (Fp) par (N).

2. Synthétiseur de fréquence selon la revendication 1,
caractérisé en ce que la fréquence caractéristique de l'oscillateur peut consister en sa fréquence minimum, sa fréquence maximum, ou même en sa fréquence moyenne.

3. Synthétiseur de fréquence selon l'une des revendications 1 et 2,
caractérisé en ce que les moyens de multiplication de la fréquence (Fq) de l'oscillateur (23) divisée par (R) sont constitués par une boucle de phase comprenant un oscillateur à fréquence variable (30) fournissant la fréquence de sortie (Fs) et attaquant un diviseur à taux variable (32) par le taux (N) dont la sortie est comparée à ladite fréquence (Fq) divisée par (R), dans un comparateur de phase (31) qui asservit l'oscillateur (30).

4. Synthétiseur selon l'une des revendications précédentes,
caractérisé en ce que les moyens de multiplication de la fréquence de l'oscillateur (23) sont constitués par deux boucles de phase, la première comportant un oscillateur à fréquence variable supplémentaire (33) qui attaque un diviseur à taux variable (34) par (N1) dont la sortie va vers un comparateur de phase (35) qui reçoit, d'une part, la fréquence (Fq) et asservit l'oscillateur (33), en ce que ce même oscillateur (33) attaque, d'autre part, un mélangeur (37) qui reçoit sur son autre entrée la fréquence de sortie (Fs) délivrée par un oscillateur à fréquence variable (36), en ce que la sortie du mélangeur (37) attaque un diviseur à taux variable (40) par (N2) dont la sortie est reliée à un comparateur de phase (39) qui assure l'asservissement de l'oscillateur (36), et en ce que l'autre entrée du comparateur de phase (39) reçoit la fréquence (Fq) divisée par un taux fixe (R) au moyen d'un diviseur (28), le taux de multiplication (N) entre (Fq) et (Fs) étant égal à (R) fois (N1) plus (N2).

FIG.1

FIG.2

FIG.3

FIG.4

FIG.5

EP 0 544 550 A1

**Office européen des brevets**

# RAPPORT DE RECHERCHE EUROPEENNE

Numero de la demande

EP 92 40 2917

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | GB-A-2 092 844 (ADRET ELECTRONIQUE) * page 2, ligne 29 - ligne 109; figure 1 * | 1,3,4 | H03L7/23 H03L7/099 |
| Y | EP-A-0 252 539 (N.V. PHILIPS GLOEILAMPENFABRIEKEN) * abrégé; figure 3 * | 1,3,4 | |
| A | GB-A-2 130 827 (GENERAL ELECTRIC CO.) * page 2, ligne 30 - ligne 35 * | 1-4 | |
| A | FR-A-2 273 401 (ADRET ELECTRONIQUE) * page 5, ligne 3 - page 8, ligne 2; figure 2 * | 1-4 | |

**DOMAINES TECHNIQUES RECHERCHES (Int. Cl.5)**

H03L

Le présent rapport a été établi pour toutes les revendications

| Lieu de la recherche | Date d'achèvement de la recherche | Examinateur |
|---|---|---|
| LA HAYE | 28 JANVIER 1993 | PEETERS M.M.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

8